# EUROPEAN PATENT APPLICATION

(11) **EP 3 940 398 A1**
(43) Date of publication of application: **19.01.2022**
(21) Application number: 21185732.1
(22) Date of filing: 15.07.2021
(51) Int. Cl.: G01R 19/155, G01R 31/327

(54) **DISCONNECT VERIFICATION**

(30) Priority: 16.07.2020 US 202063052570 P; 28.06.2021 US 202117360507
(71) Applicant: Panduit Corp., Tinley Park, Illinois 60487 (US)
(72) Inventor: Bugaris, Rachel M., Lexington, Kentucky, 40509 (US)
(74) Representative: Roberts, Gwilym Vaughan

(57) **Abstract**

A method for verifying that a disconnect is open includes providing a disconnect verification unit electrically connected to a load side of a disconnect to be verified, having the disconnect verification unit determine whether the contact for each phase of the disconnect is open, having the disconnect verification unit determine whether the leads are connected to the load side of the disconnect; and sending a signal to a user interface of a status of the disconnect.

## Description

### CROSS REFERENCE TO RELATED APPLICATION(S)

This application claims benefit to U.S. Provisional Patent Application No. 63/052,570, filed on July 16, 2020, the entirety of which is hereby incorporated by reference herein.

### FIELD OF THE INVENTION

The present invention relates generally to disconnects for eletrical systems and more speficially to a disconnect verification unit that can verify the staus of a disconnect.

### BACKGROUND

In order to establish an electrically safe work condition, several steps are required to ensure that the equipment is de-energized and prevented from becoming re-energized. Exposure to electrical hazards during this process can be reduced by incorporating permanently mounted devices to automate some of the manual steps, increasing safety and productivity of the person performing the test.

One step in the process is to verify that each phase of the disconnect is open once the operating handle has been moved to the off position. Electrical disconnects occasionally malfunction and fail to open all phases when the handle is operated. Both rotary and knife-blade disconnects can experience this type of failure, and several manufacturers have issued recalls for this reason.

Visual verification can be a challenge as the disconnect is usually enclosed in an electrical enclosure that is made from a material like steel which is not transparent.

### SUMMARY

A method for verifying that a disconnect is open includes providing a disconnect verification unit electrically connected to a load side of a disconnect to be verified, having the disconnect verification unit determine whether the contact for each phase of the disconnect is open, having the disconnect verification unit determine whether the leads are connected to the load side of the disconnect; and sending a signal to a user interface of a status of the disconnect.

### BRIEF DESCRIPTION OF THE FIGURES

Fig. 1a shows a disconnect verification unit (DVU) as an accessory to an absence of voltage tester (AVT).
Fig. 1b shows a concept where the DVU load side connections are made via the AVT.
Fig. 1c shows a concept where the DVU leads are tapping the AVT leads.
Fig. 2 shows an example of a disconnect with a visible blade.
Fig. 3 shows a concept that leverages the position of the bades of a disconnect into an AVT.
Fig. 4 shows how the position of the bades can be used to verify a disconnect is open.

### Description

The Disconnect Verification unit will electrically or mechanically verify that the disconnect is open and signal the status to a user interface(s) mounted outside of the enclosure.

In this product, verifying the disconnect is open at a minimum involves the following steps:
- Determine the contact for each phase is open (typically A, B, and C for a three-phase system);
   ∘ This concept may also apply to single phase or systems with a neutral conductor.
- Any additional diagnostics to ensure performance of the device is accurate;
- Determine that the sensor leads are connected to the circuit, if applicable. Sensor leads may be galvanic or non-galvanic, such as using capacitive coupling. There may be one or two per phase;
- Signal the result via a user interface (locally at the external enclosure of the equipment, and over a network interface, if applicable).

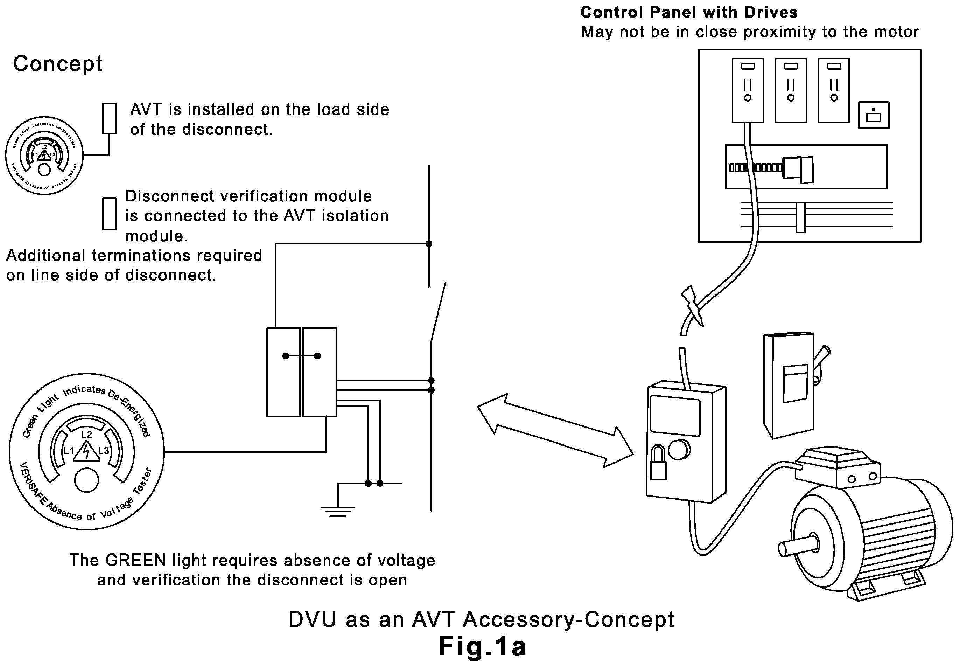

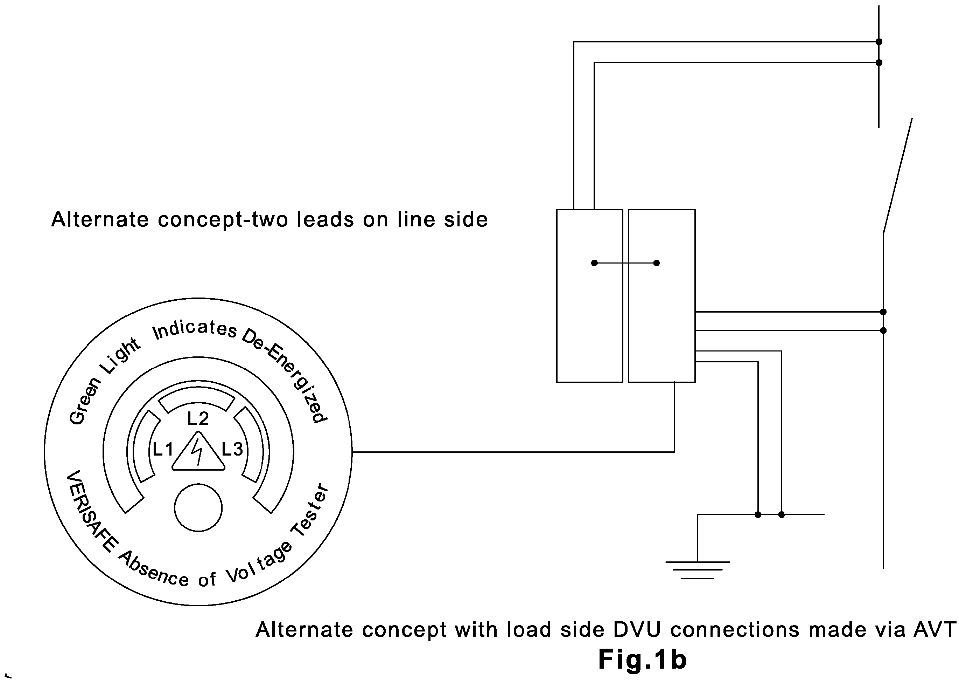

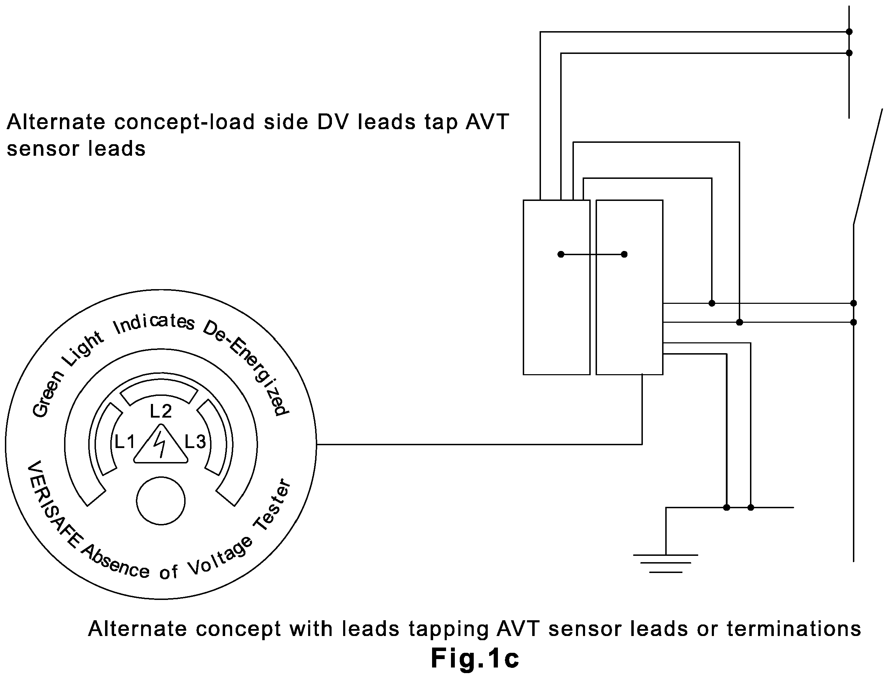

The Disconnect Verification unit could be embodied in several ways:
(1) Standalone device - used independently to verify that the contacts/blades of a switching device are open without opening the electrical enclosure with a separate user interface (an alternative way to verify -- Step 3 of 120.5 in NFPA 70E-2018. Note this is electrical verification, not visual but in many cases visual verification is not possible in electrical enclosures. Electrical verification provides a new way perform this step that is more reliable and less dependent on environmental conditions like lighting; physical barriers or guards; availability, location, and cleanliness of viewing windows, etc.);
(2) As an accessory used with the AVT - a module added to an AVT installed on the load side of a disconnect. A condition is added to the AVT test sequence that each phase of the disconnect must be open in order for the de-energized signal to be provided. This may require additional connections to the line side of the disconnect and load side of the disconnect and/or AVT with a combined user interface to initiate the test and signal the results of the AVT and Disconnect Verification Unit. (Figure 1);
(3) Incorporated into the AVT - A single tester with both AVT and DVU functionality and a single user interface. May simplify installation and wiring;
(4) Incorporated into the component with contacts that need to be verified - eliminates additional component wiring and increases reliability with factory integration.

Additionally, the interface can be incorporated into the device controls (for example, power/air circuit breaker):
a. With AVT - AVT and DVU incorporated into the component;
b. Without AVT - only DVU incorporated into the component. If an AVT is already installed or the disconnect is not the absence of voltage verification point, only a DVU may be required.

Incorporating the Disconnect Verification Unit into the component (Option 4) may make installation easier, more reliable, and the overall product more compact. Depending on how the component is configured, it may be possible to eliminate the DVU sensor lead test in the verification step simplifying complexity and size of the unit, if directly connected to the contact being tested.

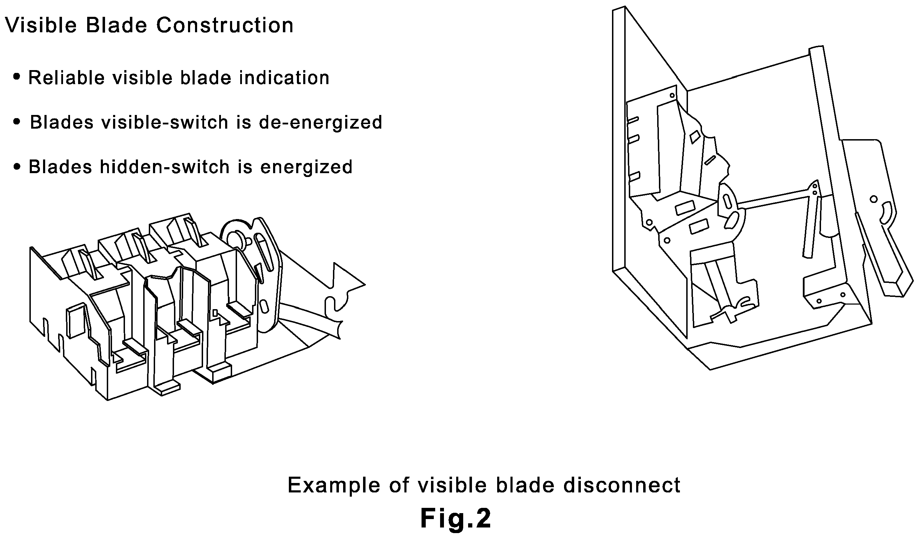

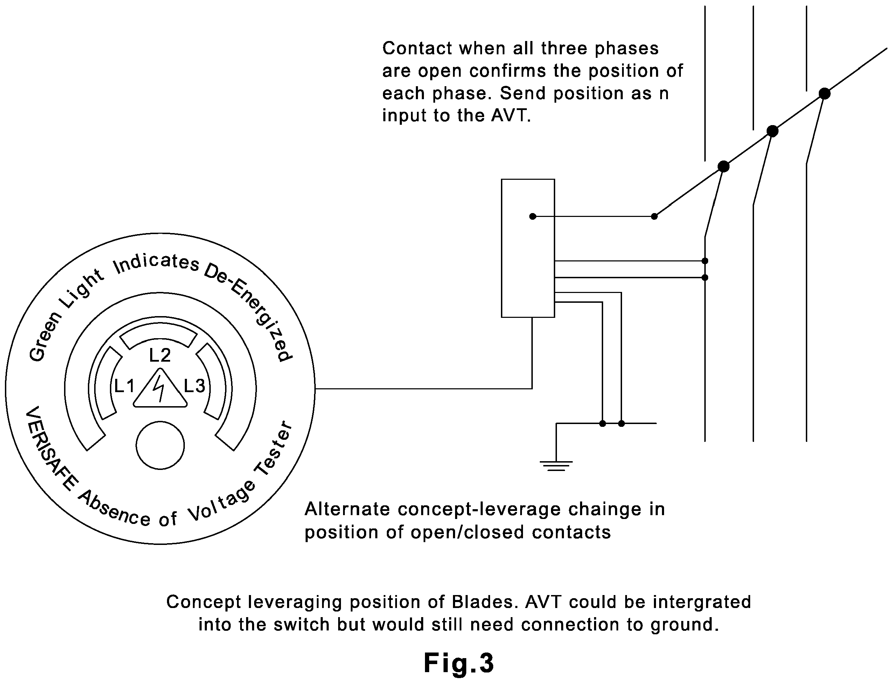

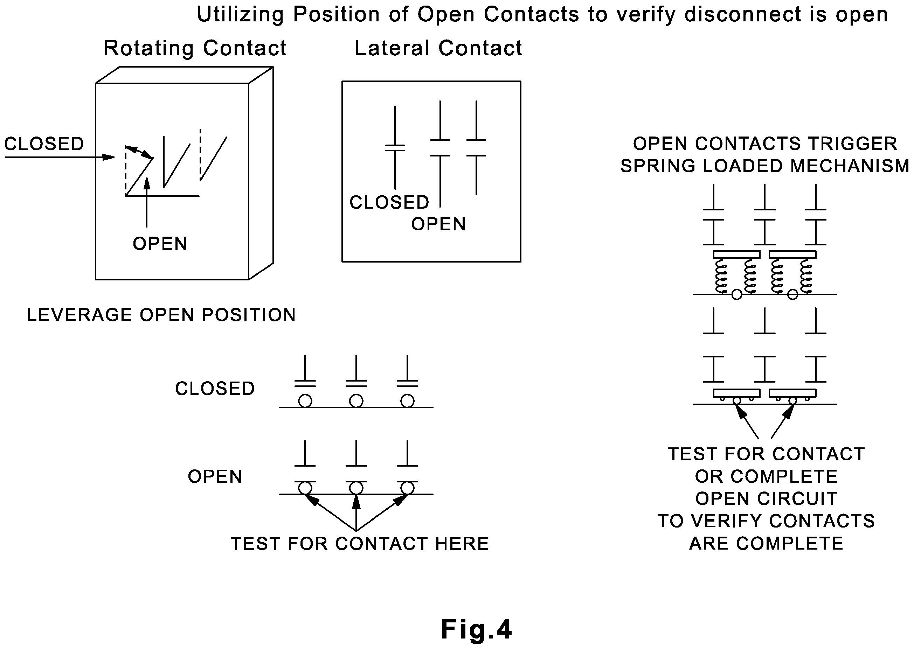

Option 4 also allows different techniques to be used to determine that the contacts are open. Rather than relying on connections on the line and load side of the contacts and an electrical test, methods that leverage the physical movement of the contacts can be utilized. When the contacts are fully open, they will be in a different position than when they are closed. (Figure 2 - example of visible blade disconnects) That mechanical movement can be leveraged so that when the contacts are open contact is made with a part or mechanism that provides electrical or mechanical feedback to verify the open status (Figure 3, 4):
a. Each contact/blade makes physical contact with a stationary sensor;
b. Continuity between all three contacts/blades to complete a stationary circuit when open.

When the contacts are open and make contact with this "test point" feedback can be sent to the AVT indicating that the contacts are open. Utilizing the open contact position as the test point, eliminates the need for additional DVU connections on the line or load side of the disconnect, making the solution more compact and easier to install. This may require 2-3 inputs to the DVU, rather than 12-14 (up to two per phase on line and load, ground).

A successful absence of voltage test and/or disconnect verification can be used as a condition that must be satisfied before access is granted to an enclosure.

In electrical equipment it is common to have the disconnect mechanically or electrically interlocked with the door of an electrical enclosure so that the door is not allowed to be opened if the disconnect is in the on position. By adding functionality, an additional level of safety can be achieved by preventing the enclosure door from being opened until the disconnect is in the off position, each phase of the disconnect is electronically verified to be open, and the absence of voltage is confirmed. This is particularly beneficial in scenarios where the upstream power was not present at the time the disconnect was placed in the off position.

This same concept can be applied to a machine or manufacturing area. Rather than (or in addition to) interlocking the disconnect to the operator handle at the door of the electrical enclosure, access could be prevented at an entry point gate or other machine boundary.

## Claims

1. A method of verifying that a disconnect is open comprising
providing a disconnect verification unit electrically connected to a load side of a disconnect to be verified;
having the disconnect verification unit determine whether the contact for each phase of the disconnect is open;
having the disconnect verification unit determine whether the leads are connected to the load side of the disconnect; and
sending a signal to a user interface of a status of the disconnect.

2. The method of claim 1 further comprising having the disconnect verification unit perform self diagnostics.

3. The method of claim 1 wherein the disconnect verification unit is incporated into an absence of voltage tester.

4. The method of claim 1 wherein an absence of voltage tester is incorporated as part of the disconnect verification unit.
